# EUROPEAN PATENT APPLICATION

(11) **EP 2 727 889 A1**
(43) Date of publication of application: **07.05.2014**
(21) Application number: 13191245.3
(22) Date of filing: 01.11.2013
(51) Int. Cl.: C03C 17/36, H04M 1/02

(54) **Window member for a portable terminal and method for fabricating same**

(30) Priority: 02.11.2012 KR 20120123772; 06.02.2013 KR 20130013251
(71) Applicant: Samsung Electronics Co., Ltd, Gyeonggi-do 443-742 (KR)
(72) Inventor: Ryu, Jong-In, 443-742 Gyeonggi-do (KR); Kim, Myung-Gon, 443-742 Gyeonggi-do (KR); Oh, Seung-Taek, 443-742 Gyeonggi-do (KR)
(74) Representative: Nederlandsch Octrooibureau

(57) **Abstract**

A window member and a method for fabricating the same. The window member includes a glass member, a semi-transparent printed layer formed on the glass member, and a metal or metal oxide layer formed on the semi-transparent printed layer. In some embodiments, the semi-transparent printed layer includes embossments formed on a surface thereof facing the metal or metal oxide layer, or contains an additive to generate virtual embossments.

## Description

### BACKGROUND

### 1. Technical Field

The present disclosure relates generally to portable terminals, and more particularly, to a window member attached onto a display device of a portable terminal.

### 2. Description of the Related Art

In general, a portable terminal such as a mobile communication terminal or a portable multimedia player includes a display module and a transparent window member attached to the display module to protect it while allowing unperturbed transmission of screen images. Many of today's display modules are also integrated with a touch screen which serves as the sole or primary data input mechanism for the portable device.

Although it is preferable that most areas of the window member are transparent to transmit screen images therethrough, an adhesive member such as a double-sided tape is typically disposed along at least the periphery of the window member in order to mount it to a housing of the portable terminal. Naturally, a part of the housing that directly supports the periphery of the window member or the adhesive member may also be visible through the window member. For aesthetics, the interior structure of the housing or the adhesive member is covered by printing layers on the window member periphery.

Definitions: in this document, when a layer or member is said to be formed or disposed "on" another layer or member, the word "on" is used from the perspective of a fabrication process and thus may be interpreted as "on a top surface" or "on a bottom surface" of the relevant layer, i.e., either "atop" or "underneath", from the perspective of a section of a completely fabricated window member.

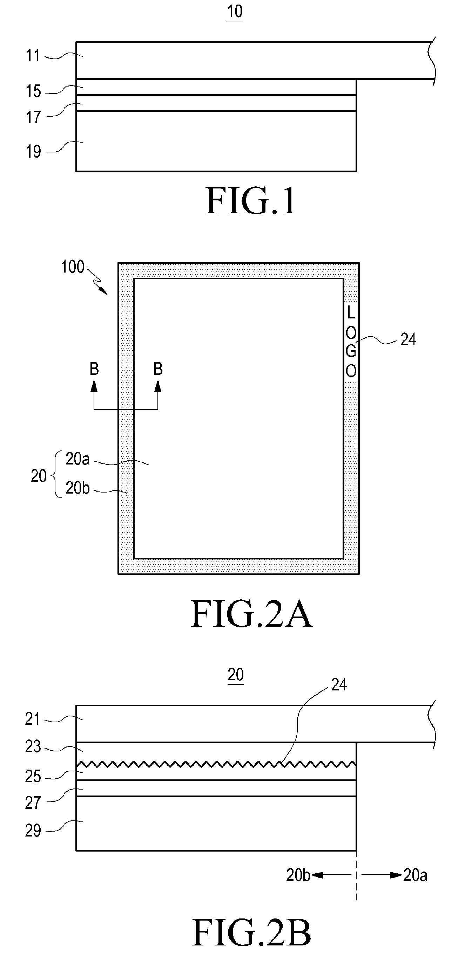

FIG. 1 is a cross-sectional view of a peripheral portion of a window member 10 in a conventional portable terminal. The window member 10 includes a glass member 11 formed by processing tempered glass, and printed layers on an edge of the glass member 11. As mentioned, the printed layers are used to cover an adhesive member or the like, including a color layer 17 formed of a colored paint. A black-series or gray-series colored shield layer 19 is formed on a surface of the color layer 17. The shield layer 19 substantially covers an adhesive member or the like (below layer 19, not shown) interposed between the window member 10 and a housing of the portable terminal. The color layer 17 gives a decorative effect to the window member 10, when viewed from the exterior of the portable terminal.

To render the window member 10 glossy, a metal oxide layer 15 may be formed on the window member 10 because the glossiness cannot be achieved simply with the color layer 17. The metal oxide layer 15 is formed between the glass member 11 and the color layer 17 by depositing a metal oxide material such as titanium dioxide (TiO₂), silicon dioxide (SiO₂), or aluminum oxide (Al₂O₃).

Along with the recent proliferation of portable terminals, user tastes of portable terminal designs have become diverse. In this context, efforts have been continuously expended toward various colors or visual effects on the exteriors of the portable terminals. However, visual effects available to the window member are limited to changing colors despite formation of the printed layers on the edges of the window member. As a result, the window member can be visually enhanced just by reinforcing the glossiness of the window member edges using the metal oxide layer.

### SUMMARY

An aspect of the present disclosure is to provide a window member for a portable terminal, to which various visual effects can be given using a printed layer formed at an edge (periphery) of the window member, and a method for fabricating the same.

Another aspect is to provide a window member for enabling various exterior designs available to a portable terminal, and a method for fabricating the window member.

In an embodiment, there is provided a window member including a glass member, a semi-transparent printed layer formed on the glass member, and a metallic layer (metal or metal oxide) formed on the semi-transparent printed layer. The semi-transparent printed layer may include embossments formed on a surface thereof facing the metallic layer, and/or may contain an additive to generate virtual embossments.

In another embodiment, there is provided a method for fabricating a window member for a portable terminal, in which a glass member is processed and a semi-transparent printed layer is formed on a surface of the glass member. The semi-transparent printed layer is formed by printing a mixture of a transparent paint and a toning paint on the surface of the glass member and curing the mixture.

### BRIEF DESCRIPTION OF THE DRAWINGS

The above and other aspects, features and advantages of certain embodiments of the present invention will be more apparent from the following detailed description taken in conjunction with the accompanying drawings, in which:
FIG. 1 is a cross-sectional view of a peripheral portion of a window member in a general portable terminal;
FIG. 2A is a simplified plan view of a portable terminal in accordance with an embodiment of the invention;
FIG. 2B is a partial cross-sectional view of a window member in a portable terminal of FIG. 2A along the lines B-B, according to an embodiment of the present invention;
FIG. 3 is a flowchart illustrating a method for fabricating the window member illustrated in FIG. 2B; and
FIGs. 4 and 5 are cross-sectional views illustrating modification examples of the window member illustrated in FIG. 2B.

Throughout the drawings, the same or like drawing reference numerals will be understood to refer to the same or like elements, features and structures.

### DETAILED DESCRIPTION OF EXEMPLARY EMBODIMENTS

Reference will be now made to exemplary embodiments of the present invention with reference to the attached drawings. A detailed description of a generally known functions and structures may be omitted to avoid obscuring the subject matter of the present invention.

FIG. 2A is simplified plan view of a portable terminal, 100, in accordance with an embodiment. Portable terminal 100 includes a window member 20 having a central portion 20a coinciding with a screen of a display module, to enable emission of screen images. A peripheral portion 20b coincides with an adhesive member that affixes the window member 20 to a housing frame of the portable terminal, and layers to cover the adhesive member and provide an aesthetic appearance. An example embossment 24 in the form of a logo is formed within the peripheral portion 20b and visible from the exterior.

FIG. 2B is a partial cross-sectional view of the window member 20 of the portable terminal 100, taken along the lines B-B of FIG. 2A, according to an embodiment. Window member 20 includes a semi-transparent printed layer 23 formed on a surface of a glass member 21. A metallic layer 25, a color layer 27, and a shield layer 29 may be sequentially stacked on the semi-transparent printed layer 23. Color layer 27 is optional; if omitted, the metallic layer 25 and shield layer 29 can interface one another. Metallic layer 25 can be formed as either a metal layer or a metal oxide layer. Particularly, the metallic layer 25 enhances a visual effect created by the semi-transparent printed layer 23 by reflecting external incident light.

The peripheral portion 20b of the window member 20 including the semi-transparent printed layer 23 produces a "ceramic feel" (equivalently, "ceramic visual effect"), i.e., a visual appearance of texture resembling a ceramic material. This visual effect is due to external light incident on the window member 20 being partially reflected from the semi-transparent printed layer 23 and the metallic layer 25 and layers 27, 29 beneath it. That is, light partially transmitted through the printed layer 23 is partially absorbed in the lower layers 27, 29 and partially reflected from the lower layers, contributing to the ceramic feel. Further, embossments 24 may be formed on a surface of the semi-transparent printed layer 23, that is, the surface of the semi-transparent printed layer 23 facing the metal oxide layer 25. Embossments 24 in some designs produce a pattern effect such as a grid pattern created along with the ceramic feel. Design embossments 24 are illustrated in the cross-section of FIG. 2B in a jagged pattern, implying an embossed surface formed of triangular-shaped channels as one possible embossment design. However, many other types of design type embossments are possible, e.g., a logo or text type embossment 24 as shown in FIG. 2A.

Preferably, the transmittance of the glass member 21 is nearly 100% because the glass member 21 should transfer screen images output from a display module (not shown) minimally perturbed. One suitable material for glass member 21 is tempered glass, in view of its high transmittance and surface strength. To protect against external impact, e.g. when the portable terminal is dropped, a protection film or a coating can be deposited on the glass member 21. Another protective technique is to deploy an engagement structure between the housing of the portable terminal and the window member 20 to distribute and dampen the external impact.

Other materials such as an inexpensive transparent synthetic resin, e.g., acrylic glass are possible for window member 20; however, a window member formed of a synthetic resin has a relatively low transmittance and is vulnerable to damage such as surface scratches. Therefore, the window member formed of a synthetic resin may be unsuitable in portable devices used for multimedia services such as videos.

The window member 20 is fixedly mounted in the housing of the portable terminal by means of an adhesive member (not shown) such as a double-sided tape, e.g. directly beneath the shield layer 29. Thus the color layer 27 and shield layer 29 cover the adhesive member between the glass member 21 and the housing, and the semi-transparent printed layer 23 provides the ceramic visual effect in conjunction with the color layer 27(if provided), shield layer 29 and the metallic layer 25. In some embodiments, the shield layer 29 can be omitted.

The semi-transparent printed layer 23 can be formed by applying a mixture of a transparent paint and a toning paint on the surface of the glass member 21, preferably along an edge of an inner surface of the glass member 21, and curing the paint mixture. The paint mixture may further contain an additive such as pearl particles, pigment particles, etc. The paint mixture may be printed by silkscreen printing, direct digital printing, or pad printing.

The embossments 24 may be formed on the surface of the semi-transparent printed layer 23 by wet etching or dry etching. The wet etching involves development and etching using a photoresist, whereas the dry etching uses plasma. The embossments 24 may be formed on the semi-transparent printed layer 23 through such surface processing and the embossments 24 may be arranged into a specific pattern. In the case of digital printing, it is possible to form the embossments 24 on the surface of the semi-transparent printed layer 23 during printing. In other words, when the semi-transparent printed layer 23 is formed by digital printing, surface processing is not always needed to form the embossments 24.

Even if embossments 24 formed by surface processing are omitted, a visual (or virtual) embossing effect may be created by varying a color, giving a haze effect, and/or changing the surface roughness of the semi-transparent printed layer 23 according to an additive of the paint forming the semi-transparent printed layer 23. That is, various visual effects can be achieved by means of the semi-transparent printed layer 23 itself using an additive and a flatting agent as well as the mixture of the transparent paint and the toning paint.

The metallic layer 25 is formed by depositing a metal or metal oxide on the surface of the semi-transparent printed layer 23. The deposition affinity of the metal oxide may be increased relative to conventional window members, since the semi-transparent printed layer 23 is effective as a primer. The metallic layer 25, when embodied as a metal oxide layer, can be formed by metallic material, for example, one of titanium dioxide (TiO₂), silicon dioxide (SiO₂), and aluminum oxide ( Al₂O₃) and depositing the metallic material on the surface of the semi-transparent printed layer 23. As mentioned earlier, the metallic layer 25 enhances the glossy effect by reflecting external light incident on the window member 20.

The color layer 27, when included, is formed on the metallic layer 25; otherwise, shield layer 29 is formed on metallic layer 25. The color layer 27 is formed by printing an achromatic or chromatic paint on a surface of the metallic layer 25 and curing the paint. The shield layer 29 is formed by printing a black-series or gray-series paint on the surface of the metallic layer 25 or the color layer 27 and curing the paint. The color layer 27 may provide a distinctive color at the edge of the window member 20. The color layer 27 may be omitted, depending on an intended design of a terminal to which the window member 20 is attached. That is, if the color of the semi-transparent printed layer 23 suffices for an intended design of the terminal, the color layer 27 may be omitted, and the shield layer 29 may be formed directly on the surface of the metal oxide layer 25.

The shield layer 29 fully or substantially shields transmission of light through the edge of the window member 20. That is, because the semi-transparent printed layer 23 or the metallic layer 25 has a certain level of transmittance, it does not fully cover the adhesive member and the adjoining housing. Therefore, the adhesive member, etc. beneath the window member 20 is perfectly or near perfectly covered by forming the shield layer 29 of a black-series or gray-series paint on the metallic layer 25.

In this manner, the window member 20 having the semi-transparent printed layer 23 can generate the ceramic visual effect by means of light reflected from the metallic layer 25 as well as external incident light partially reflected from the printed layer 23 itself. Further, various visual effects can be achieved at the edge of the window member 20 by forming the embossments 24 on the surface of the semi-transparent printed layer 23.

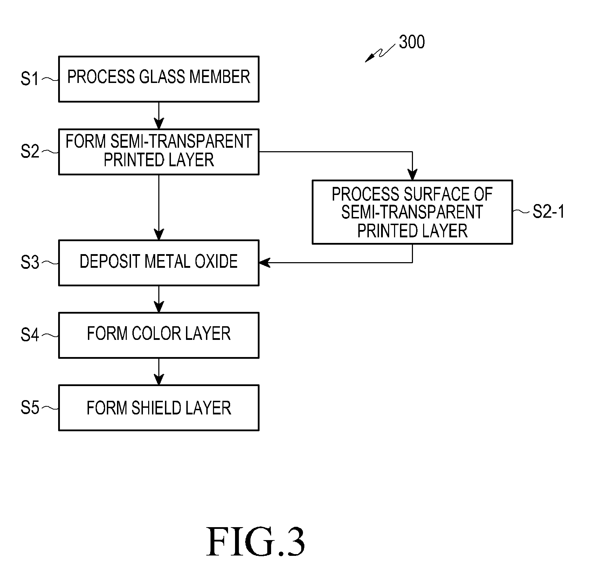

FIG. 3 is a flowchart illustrating an exemplary method 300 for fabricating the window member 20. The method involves forming the semi-transparent printed layer 23 on one surface of the glass member 21 (S2) after processing the glass member 21 (S1). The method will be described with reference to FIGs. 2A and 2B.

As described earlier, the semi-transparent printed layer 23 can be formed by printing a mixture of a transparent paint and a toning paint on one surface of the glass member 21 and curing the paint mixture (S2). The paint mixture may further contain an additive such as pigment particles. The semi-transparent printed layer 23 is formed by printing the paint mixture on the surface of the glass member 21 by silkscreen printing, digital printing, or pad printing and then curing the paint mixture.

When included, the embossments 24 can be formed by processing the surface of the semi-transparent printed layer 23 (S2-1). The embossment formation step involves wet etching or dry etching, generally dry etching such as plasma etching. The embossments 24 may represent an array of specific figures or patterns or a symbol or logo of a communication service provider / a manufacturer formed with characters. If frequently used hot keys such as a menu key or a call start/end key are disposed at permanent positions, text or symbols representing the positions and functions of the hot keys may be formed using the embossments 24. Note that in this case, touch screen elements are provided in a suitable manner, within or below the glass member 21 in the region of the embossments 24.

Meanwhile, the step of forming the embossments 24 S2-1 by processing the surface of the semi-transparent printed layer 23 may be omitted, as discussed above. This means that step S2-1 is selectively performed according to the exterior design of the portable terminal equipped with the window member 20. If the semi-transparent printed layer 23 is formed by digital printing, it is possible to form the embossments 24 simultaneously with formation of printed layer 23 according to the additive contained in printed layer 23, which obviates the need for performing the surface processing step S2-1 for forming the embossments 24.

Metallic layer 25, when formed as a metal oxide layer, is formed by depositing a metal oxide on the surface of the semi-transparent printed layer 23 (S3). The deposition affinity of the metal oxide is increased relative to conventional window members, since the semi-transparent printed layer 23 has properties of a primer. Preferably, the metallic layer 25 is formed of a metallic material of one of titanium dioxide (TiO₂), silicon dioxide (SiO₂), and aluminum oxide ( Al₂O₃). The metallic material, e. g. metal oxide is deposited by placing the glass member 21 having the semi-transparent printed layer 23 formed on it in a deposition chamber. To increase the deposition affinity of the metal oxide on the glass member 21, an additional primer is required. In an embodiment of the present invention, the semi-transparent printed layer 23 has the dual function of generating the ceramic feel and, acting as a primer to increase the deposition affinity of the metal oxide.

The color layer 27 can be formed by printing an achromatic or chromatic paint on a surface of the metal oxide layer 25 and curing the paint (S4). As the color layer 27 is formed, the color of the edge of the window member 20 becomes clearer. Various colors are available for the color layer 27 according to the color of the achromatic or chromatic paint. It should be noted, if the color created by the semi-transparent printed layer 23 is sufficient for an intended design for a portable terminal to which the window member 20 is mounted, the color layer formation step S4 may be omitted.

The shield layer 29 is formed by printing a black-series or gray-series paint on a surface of the metallic layer 25 and curing the paint (S5). As described above, if color layer 27 is omitted, the shield layer 29 may be formed directly on the surface of the metallic layer 25.

The adhesive member, etc. can be covered by forming the printed layers at the edge of the window member through the above operation. In addition, the semi-transparent printed layer formed on the window member creates the ceramic visual effect using light reflected from the metallic layer as well as external incident light absorbed and reflected by the semi-transparent printed layer itself. If embossments are formed on the semi-transparent printed layer, more decorative patterns can be achieved.

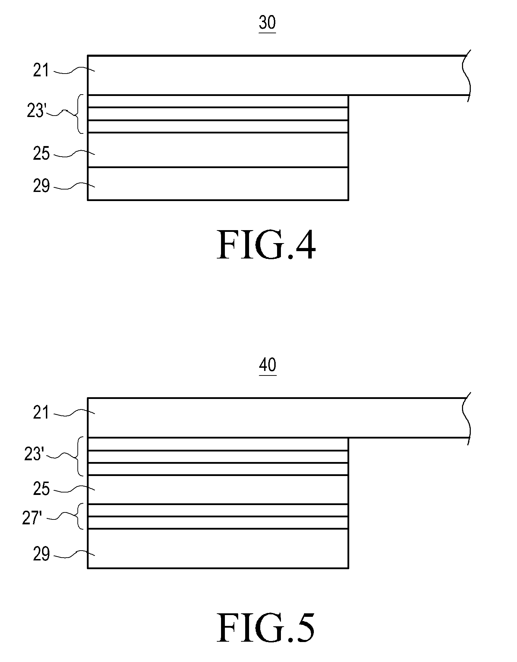

FIGs. 4 and 5 illustrate modification examples of the window member illustrated in FIGS. 2A and 2B. Compared to the window according to the afore-described embodiment of the present invention, the window members illustrated in FIGs. 4 and 5 include a semi-transparent printed layer or color layer that has a plurality of layers. Therefore, the same or like reference numerals, or no reference numerals are designated for the same or like components readily understood from the afore-described embodiment, and a description of some components is omitted for conciseness of explanation.

The window member 30 illustrated in FIG. 4 includes a semi-transparent printed layer 23' between a glass member 21 and a metallic layer 25. The semi-transparent printed layer 23' has a plurality of layers. The window member 30 further includes a shield layer 29 directly formed on the surface of the metal oxide layer. Thus, the window member 30 is not provided with the color layer of the afore-described embodiment.

As illustrated in FIG. 4, the plurality of layers of the semi-transparent printed layer 23' in the window member 30 differ in brightness or chroma. Specifically, if the various layers in printed layer 23' are achromatic colors such as a white, black or gray series, they may differ in brightness. If the printed layers are chromatic colors, they may differ in chroma. The brightness or chroma may be adjusted by differentiating the density of a toning ink to be mixed with a transparent ink, and pearl particles or pigment particles may be added depending on a product design.

The semi-transparent printed layer is formed by performing silkscreen printing, digital printing, or pad printing at least twice. The printed layers of the semi-transparent printed layer 23' may vary in brightness or chroma by using a different paint during each printing operation.

FIG. 5 illustrates a window member 40 according to an embodiment, including a plurality of color layers between the metallic layer and the shield layer. The color layers 27' may also be formed by printing a mixture of a transparent ink and a toning ink. Thus, while a layer interposed between the glass member 21 and the metallic layer 25 and a layer interposed between the metallic layer 25 and the shield layer 29 are respectively referred to as "a semi-transparent printed layer" and "a color layer" in order to distinguish them from each other, the color layer 27' may be formed substantially in the same manner as the semi-transparent printed layer 23'.

Since the semi-transparent printed layer and/or the color layer includes a plurality of layers at different brightness or chroma levels as described above, various visual effects, for example, various depth illusions can be achieved.

The plurality of layers of the semi-transparent printed layer 23' or the plurality of color layers 27' may be formed by repeating the step of forming a semi-transparent printed layer or a color layer in the afore-described embodiment. Thus, a detailed description of the step of forming the layers of the semi-transparent printed layer or the color layers in FIG. 4 or FIG. 5 is omitted.

As is apparent from the above description of embodiments of the present invention, the window member can provide a ceramic feel as external incident light penetrates through the semi-transparent printed layer and further light reflected from the metallic layer is transmitted through the semi-transparent printed layer. Various colors can be achieved by adding a toning paint or an additive in forming the semi-transparent printed layer. Since a pattern can be formed by means of embossments resulting from processing the surface of the cured semi-transparent printed layer, various decorative effects can be created on the window member. If a plurality of layers are formed at different brightness or chroma levels for the semi-transparent printed layer, they can impart a gradation effect, thus achieving various visual effects. Consequently, various interior designs are available to a portable terminal by mounting a window member in accordance with the present invention to the portable terminal.

While embodiments of the present invention has been particularly shown and described with reference to specific examples, it will be understood by those of ordinary skill in the art that various changes in form and details may be made therein without departing from the scope of the present invention as defined by the following claims. Features of the exemplary embodiments may be combined to form further embodiments according the invention.

## Claims

1. A window member (20, 30, 40) for a portable terminal (100), comprising a glass member (21), **characterized by**:
a semi-transparent printed layer (23, 23') formed on the glass member; and
a metallic layer (25) formed on the semi-transparent printed layer.

2. The window member (20, 30, 40) of claim 1, wherein the semi-transparent printed layer (23, 23') includes embossments (24) formed on a surface of the semi-transparent printed layer facing the metallic layer.

3. The window member (20, 30, 40) of claim 1 or 2, wherein the semi-transparent printed layer is formed by printing a mixture of a transparent paint and a toning paint on a surface of the glass member and curing the mixture.

4. The window member (20, 30, 40) of any one of the previous claims, wherein the semi-transparent printed layer further contains an additive.

5. The window member (20, 30, 40) of any one of the previous claims, wherein the metallic layer is a metal oxide layer formed by depositing a metallic material of one of titanium dioxide (TiO₂), silicon dioxide (SiO₂), and aluminum oxide (Al₂O₃).

6. The window member (20, 30, 40) of any one of the previous claims, further comprising a color layer (27, 27') formed on the metallic layer, wherein the color layer is formed by printing an achromatic or chromatic paint.

7. The window member (20, 30, 40) of any one of the claims 1-5, further comprising a shield layer (29) formed on the metallic layer, wherein the shield layer is formed by printing a black or gray paint.

8. The window member (20, 30, 40) of claim 6, further comprising a shield layer (29) formed on the color layer (27, 27'), wherein the shield layer is formed by printing a black or gray paint.

9. The window member (30, 40) of any one of the claims 1-5, wherein the semi-transparent printed layer (23') includes a plurality of printed layers that differ in brightness or chroma.

10. The window member (30, 40) of claim 9, further comprising a shield layer (29) formed on or beneath the metallic layer, wherein the shield layer is formed by printing a black or gray paint.

11. The window member (40) of claim 10, further comprising a plurality of color layers (27') between the metallic layer and the shield layer, wherein the color layers are semi-transparent color layers that differ in brightness or chroma.

12. A method (300) for fabricating a window member (20, 30, 40) for a portable terminal, the method comprising:
processing (S1) a glass member; and
forming (S2) a semi-transparent printed layer on a surface of the glass member,
wherein the semi-transparent printed layer is formed by printing a mixture of a transparent paint and a toning paint on the surface of the glass member and curing the mixture.

13. The method (300) of claim 12, further comprising mixing an additive to the semi-transparent printed layer to form a mixture of the additive, the transparent paint, and the toning paint, and curing the mixture thereof.

14. The method (300) of claim 12 or 13, wherein the formation of a semi-transparent printed layer comprises forming a plurality of printed layers that differ in brightness or chroma.

15. The method (300) of any one of the claims 12-14, further comprising forming (S3) a metallic layer by depositing a metal oxide on a surface of the semi-transparent printed layer.
